(19) Europäisches Patentamt / European Patent Office / Office européen des brevets

(11) **EP 3 708 964 B1**

(12) **FASCICULE DE BREVET EUROPEEN**

(45) Date de publication et mention de la délivrance du brevet:
**24.07.2024 Bulletin 2024/30**

(21) Numéro de dépôt: **20162813.8**

(22) Date de dépôt: **12.03.2020**

(51) Classification Internationale des Brevets (IPC):
**G01D 5/14** *(2006.01)*

(52) Classification Coopérative des Brevets (CPC):
**G01D 5/145;** G01D 5/24438; G01D 5/2451

(54) **SYSTÈME DE DÉTERMINATION D'AU MOINS UN PARAMÈTRE DE ROTATION D'UN ORGANE TOURNANT**

SYSTEM ZUR BESTIMMUNG MINDESTENS EINES PARAMETERS DER ROTATION EINES ROTATIONSORGANS

SYSTEM FOR DETERMINING AT LEAST ONE ROTATION PARAMETER OF A ROTATING MEMBER

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **12.03.2019 FR 1902523**

(43) Date de publication de la demande:
**16.09.2020 Bulletin 2020/38**

(73) Titulaire: **NTN Europe**
**74000 Annecy (FR)**

(72) Inventeurs:
• **DURET, Christophe**
**74290 Bluffy (FR)**

• **FLAMMIER, Cécile**
**74000 Annecy (FR)**
• **VANDAMME, Etienne**
**74540 Alleves (FR)**

(74) Mandataire: **Sayettat, Julien Christian**
**Strato-IP**
**63, Boulevard de Ménilmontant**
**75011 Paris (FR)**

(56) Documents cités:
**EP-A1- 2 163 851     EP-A2- 1 202 025**
**JP-A- 2003 097 971     JP-A- H02 307 011**

**Description**

L'invention concerne un système de détermination d'au moins un paramètre de rotation d'un organe tournant, ledit système comprenant un codeur émettant un champ magnétique périodique ainsi qu'un capteur apte à détecter ledit champ magnétique.

Dans de nombreuses applications, on souhaite connaître en temps réel et avec une qualité optimale au moins un paramètre de rotation d'un organe tournant, tel que sa position, sa vitesse, son accélération ou son sens de déplacement.

Pour ce faire, les documents WO-2006/064169 et JP-H02/307011 proposent l'utilisation d'un codeur destiné à être solidaire de l'organe mobile et sur lequel est formée une piste magnétique qui est apte à émettre un champ magnétique pseudo-sinusoïdal à distance de lecture d'un capteur comprenant plusieurs éléments sensibles.

De façon avantageuse, chaque élément sensible peut comprendre au moins un motif à base d'un matériau magnétorésistif à effet tunnel (TMR en anglais pour Tunnel Magnéto Resistance) dont la résistance varie en fonction du champ magnétique détecté, tel que par exemple décrit dans le document WO-2004/083881.

Pour déterminer un paramètre de déplacement de l'organe mobile en fonction de l'évolution du champ magnétique détecté, le document WO-2006/064169 prévoit une combinaison des signaux représentatifs de la résistance de chacun des éléments sensibles afin de délivrer deux signaux en quadrature et de même amplitude qui peuvent être utilisés pour calculer ledit paramètre.

Le document WO-2018/051011 propose un système de détermination dans lequel la piste du codeur présente une alternance de pôles magnétiques Nord et Sud séparés par des transitions s'étendant chacune suivant une spirale d'Archimède. En relation avec une lecture axiale du champ magnétique délivré par le codeur, cette réalisation permet de dissocier le nombre de pôles magnétiques, la largeur de ceux-ci et le diamètre du codeur. Il est ainsi possible d'avoir peu de pôles tout en gardant des signaux magnétiques de bonne sinusoïdalité.

Par ailleurs, certaines applications nécessitent une lecture radiale du champ magnétique délivré par le codeur, notamment du fait des contraintes d'encombrement disponible. Pour ce faire, on connaît des codeurs comprenant un corps présentant une périphérie cylindrique sur laquelle la piste magnétique est formée, ladite piste présentant des transitions magnétiques alignées avec l'axe de rotation.

Dans cette réalisation, la largeur des pôles est le rapport de la circonférence sur le nombre de pôles, ce qui pose problème avec des codeurs au faible nombre de paires de pôles, typiquement inférieur à 6, puisque la largeur polaire devient importante, notamment de l'ordre de la dizaine de millimètres.

Ces pôles larges délivrent un signal magnétique dont la sinusoïdalité est mauvaise à faible entrefer de lecture, en devenant riche en harmoniques impaires, impropres à une mesure précise de l'angle, nécessitant un éloignement des éléments sensibles de la piste magnétique, ce qui va à l'encontre de l'amplitude dudit signal et donc de sa bonne détection par les éléments sensibles.

De plus, des pôles larges nécessitent une épaisseur du codeur elle-aussi plus importante afin de préserver une sinusoïdalité et une amplitude suffisantes pour le signal magnétique. Ceci n'est pas favorable à l'intégration du codeur dans des dimensions réduites et complexifie le procédé d'aimantation, car une plus grande épaisseur de matériau doit être saturée magnétiquement.

On connaît par ailleurs du document JP-2003-97971 un système dans lequel deux capteurs sont disposés par rapport à une piste magnétique pour mesurer la même composante unidirectionnelle d'un champ magnétique en deux emplacements, lesdits emplacements étant déterminés pour que les signaux délivrés par lesdits capteurs soient en quadrature.

L'invention vise à perfectionner l'art antérieur en proposant notamment un système de détermination à lecture radiale du champ magnétique délivré par un codeur, dans lequel le compromis entre la périodicité et l'amplitude du champ magnétique détecté peut être satisfait sans induire de contrainte d'encombrement spécifique pour le codeur, et ce en particulier en relation avec un codeur magnétique à faible nombre de paires de pôles.

En particulier, le codeur à lecture radiale suivant l'invention est tel que la largeur polaire de chacun des pôles est indépendante du nombre de paires de pôles, pouvant ainsi concilier un faible nombre de paires de pôles avec un positionnement adéquat des éléments sensibles relativement à la sinusoïdalité et à l'amplitude du champ magnétique à détecter.

A cet effet, l'invention propose un système de détermination d'au moins un paramètre de rotation d'un organe tournant selon la revendication 1.

D'autres particularités et avantages de l'invention apparaîtront dans la description qui suit, faite en référence aux figures jointes, dans lesquelles :

- les figures 1a et 1b représentent de façon schématique un codeur d'un système de détermination selon l'invention, respectivement en perspective (figure 1a) et en vue de côté (figure 1b) ;
- la figure 2 est une représentation à plat de la périphérie cylindrique du codeur des figures 1a et 1b ;

- la figure 3 représente de façon schématique une réalisation de la disposition à distance de lecture radiale d'un montage d'éléments sensibles par rapport à un codeur selon un exemple;
- la figure 4 est un schéma d'un montage d'éléments sensibles selon un exemple;
- la figure 5 représente des signaux en quadrature délivrés par le montage selon la figure 4 ;
- la figure 6 représente de façon schématique une réalisation de la disposition à distance de lecture radiale de deux montages d'éléments sensibles par rapport à un codeur suivant l'invention ;
- la figure 7 est un schéma de l'intégration des montages de la figure 6 dans un dispositif de soustraction ;
- la figure 8 est une courbe montrant le filtrage de l'harmonique de rang 3 en fonction de la distance entre les montages d'éléments sensibles des capteurs.

En relation avec ces figures, on décrit un système de détermination d'au moins un paramètre de rotation d'un organe tournant par rapport à une structure fixe. En particulier, le paramètre de l'organe tournant peut être choisi parmi sa position, sa vitesse, son sens de rotation, son accélération ou son sens de déplacement, notamment axial.

Dans une application particulière, le système peut être utilisé en relation avec le pilotage d'un moteur électrique à courant continu sans balai, permettant notamment de connaître la position angulaire absolue sur une paire de pôles moteur du rotor par rapport au stator.

Le système de détermination comprend un codeur 1 destiné à être solidaire de l'organe tournant de sorte à se déplacer conjointement avec lui, ledit codeur comprenant un corps présentant une périphérie cylindrique de rayon a autour d'un axe de révolution X sur laquelle est formée une piste magnétique 2 qui est apte à émettre un champ magnétique périodique représentatif de la rotation dudit codeur. En particulier, le champ magnétique émis peut être sinusoïdal ou pseudo-sinusoïdal, c'est-à-dire présentant au moins une portion qui peut être approximée correctement par une sinusoïde.

La piste 2 présente une alternance de pôles magnétiques Nord 2n et Sud 2s de largeur l qui sont séparés par des transitions 3, chacune desdites transitions s'étendant suivant une hélice de pas p et d'angle a.

Ainsi, la piste magnétique présente $N_{pp}$ paires de pôles Nord et Sud et une largeur polaire $L_p$ mesurée le long d'une normale N aux transitions 3 qui sont tels que : $N_{pp} = \pi a/l$ et $L_p = p.cosa$. La piste magnétique 2 délivre un signal magnétique pseudo-sinusoïdal dont la période spatiale selon la normale N est égale à $\lambda = 2.L_p$. En particulier, le champ magnétique périodique délivré par la piste magnétique 2 est tournant dans un plan perpendiculaire à ladite piste magnétique et aux transitions 3.

Le champ magnétique généré par le codeur 1 sur une paire de pôles magnétiques 2n, 2s est la combinaison d'une composante fondamentale, sinusoïdale parfaite que l'on souhaite mesurer pour déterminer le paramètre, et de plusieurs harmoniques de rang impair (3, 5, etc...).

Si l'on suppose que le codeur 1 tourne à une vitesse de rotation constante $\omega$, le champ magnétique peut être écrit de la façon suivante :

$$H(t) = H_1.sin\omega t + H_3.sin3\omega t + H_5.sin5\omega t + \ ...$$

L'amplitude $H_3$ de l'harmonique de rang 3 peut représenter typiquement 5% de l'amplitude $H_1$ de la fondamentale. Selon la position du capteur et la distance de lecture, cette proportion de l'amplitude $H_3$ de l'harmonique de rang 3 peut être très supérieure.

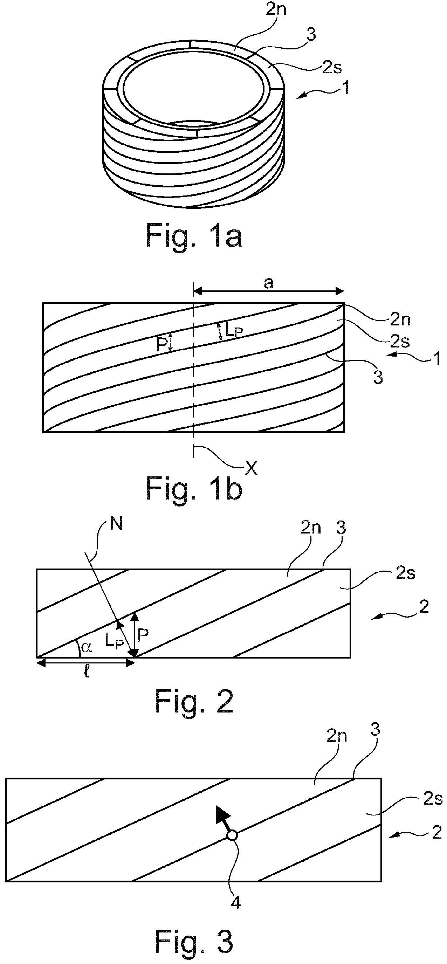

La géométrie en hélice de la piste magnétique 2 permet notamment que le nombre $N_{pp}$ de paires de pôles 2n, 2s ainsi que la largeur polaire $L_p$ puissent être choisis indépendamment du rayon a de la piste magnétique 2. En relation avec les figures 1a et 1b, le codeur 1 comprend quatre paires de pôles 2n, 2s, ce qui est particulièrement adapté pour le pilotage d'un moteur électrique à quatre paires de pôles, le système fournissant la position absolue sur une paire de pôles moteur, soit 90° mécanique.

Selon une réalisation, le codeur 1 est formé d'un aimant sur la périphérie cylindrique duquel la piste magnétique multipolaire 2 est réalisée. En particulier, l'aimant peut être formé d'une matrice annulaire, par exemple réalisée à base d'un matériau plastique ou élastomère, dans laquelle sont dispersées des particules magnétiques, notamment des particules de ferrite ou de terres rares comme le NdFeB.

Le système de détermination comprend au moins un capteur qui est destiné à être solidaire de la structure fixe, ledit capteur étant apte à détecter le champ magnétique tournant émis par le codeur 1. Pour ce faire, le capteur comprend un montage 4 d'au moins deux éléments sensibles magnétiques 5, ledit montage étant disposé à distance de lecture radiale de la piste magnétique 2 pour délivrer des signaux en quadrature qui sont représentatifs de la rotation du codeur 1.

Chacun des éléments sensibles 5 peut notamment être choisi parmi les sondes magnétosensibles. Par exemple, des sondes à base d'effet Hall, de magnétorésistances à effet tunnel (TMR), de magnétorésistances anisotropes (AMR) ou de magnétorésistances géantes (GMR) peuvent mesurer chacune des deux composantes du champ magnétique (normale et tangentielle au codeur 1).

En particulier, comme décrit dans le document WO-2004/083881, chaque élément 5 forme une jonction tunnel en comprenant un empilement d'une couche magnétique de référence, d'une couche de séparation isolante et d'une couche magnétique sensible au champ à détecter, la résistance de l'empilement étant fonction de l'orientation relative de l'aimantation des couches magnétiques.

De manière avantageuse, chaque élément sensible 5 peut comprendre au moins un motif à base d'un matériau magnétorésistif, notamment à effet tunnel, dont la résistance varie en fonction du champ magnétique, un élément sensible 5 pouvant comprendre un seul motif ou un groupe de motifs reliés en série ou en parallèle.

Pour pouvoir déterminer le paramètre de rotation de l'organe tournant, les signaux délivrés par le montage 4 d'éléments sensibles 5 doivent être préférentiellement en quadrature, c'est-à-dire déphasés géométriquement de 90° divisé par $N_{pp}$. En particulier, par exploitation de tels signaux en quadrature, dans le capteur ou dans un calculateur associé, il est connu de déterminer la position angulaire du codeur 1, par exemple par un calcul direct d'une fonction arctangente, à l'aide d'une « Look-Up Table » (LUT) ou grâce à une méthode de type CORDIC.

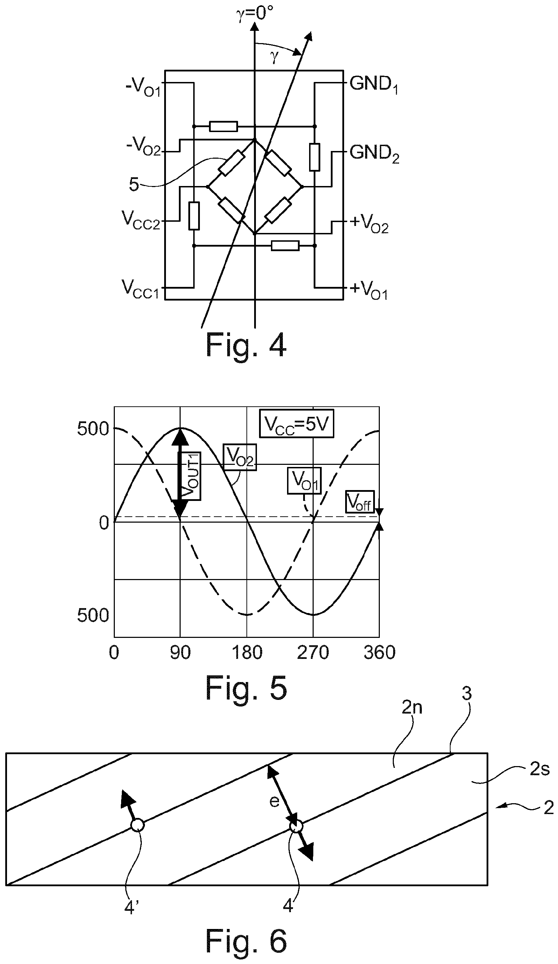

Pour ce faire, en relation avec la figure 4, le montage 4 peut comprendre deux circuits en pont de Wheatstone de quatre éléments sensibles 5, lesdits circuits étant disposés dans un plan perpendiculaire à la piste magnétique 2 de sorte à détecter le champ magnétique tournant dans ledit plan qui est émis par ladite piste.

En particulier, en fonction de l'angle $\gamma$ d'inclinaison du champ magnétique, la figure 5 représente les signaux $V_{01}$ et $V_{02}$ délivrés en quadrature par le pont qui sont tels que :

$$V_{01} = (+V_{01}) - (-V_{01}) \; ;$$

$$V_{02} = (+V_{02}) - (-V_{02}).$$

En relation avec une application du système au pilotage d'un moteur électrique, la bonne sinusoïdalité du signal délivré au calculateur de pilotage permet notamment :

- de meilleures performances, notamment au démarrage, par exemple le temps pour atteindre la consigne de vitesse ou de position ;
- un fonctionnement plus « doux », sans saut de couple en régime établi ;
- une plus faible consommation d'énergie ;
- une température de fonctionnement inférieure ;
- un couple maximum plus important.

En particulier, la figure 3 représente un montage 4 en position médiane de la périphérie du codeur 1 pour être éloigné au maximum des bords dudit codeur.

En relation avec la figure 6, le système de détermination comprend selon l'invention deux capteurs dont les montages 4, 4' sont espacés d'une distance e mesurée le long de la normale N aux transitions 3 en délivrant respectivement des signaux $V_{01}$, $V_{02}$ et $V'_{01}$, $V'_{02}$ en quadrature, ledit système comprenant en outre un dispositif de soustraction des signaux pour former des signaux SIN, COS en quadrature.

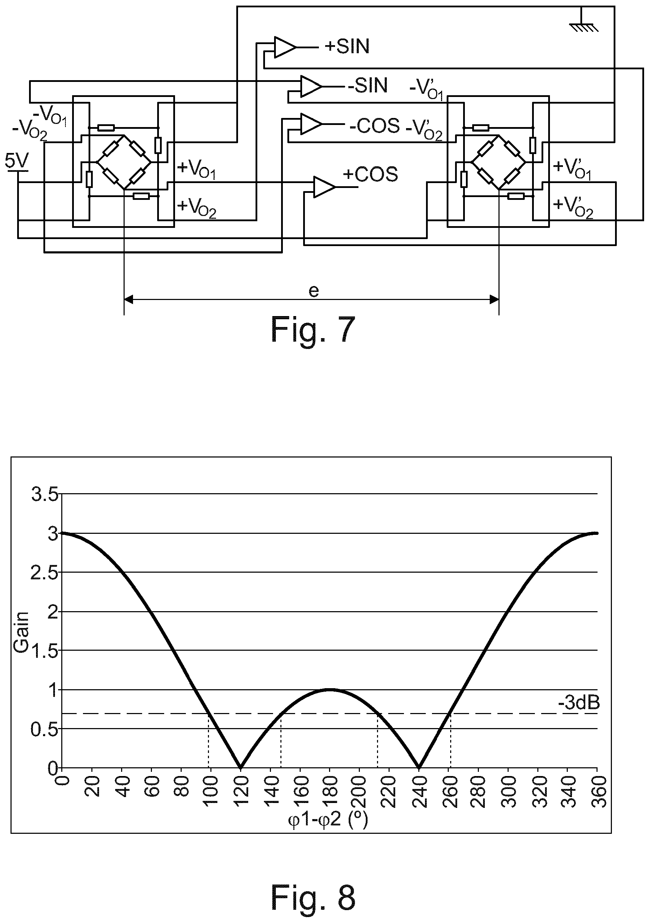

La figure 7 représente une réalisation dans laquelle les signaux formés sont :

$$SIN = (+SIN) - (-SIN) \; ;$$

+SIN étant égal à $(+V_{01})$ - $(+V'_{01})$,
-SIN étant égal à $(-V_{01})$ - $(-V'_{01})$ ;

$$COS = (+COS) - (-COS) \; ;$$

+COS étant égal à $(+V_{02})$ - $(+V'_{02})$,
-COS étant égal à $(-V_{02})$ - $(-V'_{02})$.

Cette réalisation permet un filtrage du bruit venant de l'extérieur (par exemple du moteur ou des interconnexions voisines). En effet, si le champ magnétique comporte une composante de bruit identique sur les différents montages 4, 4', celle-ci sera soustraite des signaux de sortie SIN, COS.

En positionnant les montages 4, 4' aux phases magnétiques respectivement $\varphi_1$ et $\varphi_2$, c'est-à-dire en les espaçant d'une distance e mesurée le long de la normale N aux transitions 3 qui est telle que $\varphi_1 - \varphi_2 = \dfrac{e}{2L_p} * 360$, les signaux V$_1$ = +COS ou +SIN et V$_2$ = -COS ou -SIN délivrés peuvent s'écrire :

$$V_1(t) = G.H_1.\sin(\omega t + \varphi_1) + G.H_3.\sin(3\omega t + 3\varphi_1) + G.H_5.\sin(5\omega t + 5\varphi_1) + \ldots$$

$$V_2(t) = G.H_1.\sin(\omega t + \varphi_2) + G.H_3.\sin(3\omega t + 3\varphi_2) + G.H_5.\sin(5\omega t + 5\varphi_2) + \ldots$$

G étant le gain supposé identique des montages 4, 4', $\omega$ étant la vitesse de rotation, H$_i$ étant l'amplitude de la fondamentale pour i=1 et des harmoniques de rang i pour i=3, 5, etc.

Un circuit soustracteur effectue la différence SIN ou COS qui s'écrit alors :

$$
\begin{aligned}
V_1(t) - V_2(t) = {} & G.H_1.\left[\sin(\omega t + \varphi_1) - \sin(\omega t + \varphi_2)\right] \\
& + G.H_3.\left[\sin(3\omega t + 3\varphi_1) - \sin(3\omega t + 3\varphi_2)\right] \\
& + G.H_5.\left[\sin(5\omega t + 5\varphi_1) - \sin(5\omega t + 5\varphi_2)\right] + \ldots
\end{aligned}
$$

$$
\begin{aligned}
= {} & 2.G.H_1.\sin\left(\frac{\varphi_1 - \varphi_2}{2}\right).\cos\left(\omega t + \frac{\varphi_1 + \varphi_2}{2}\right) \\
& + 2.G.H_3.\sin\left(3.\frac{\varphi_1 - \varphi_2}{2}\right).\cos\left(3\omega t + 3.\frac{\varphi_1 + \varphi_2}{2}\right) \\
& + 2.G.H_5.\sin\left(5.\frac{\varphi_1 - \varphi_2}{2}\right).\cos\left(5\omega t + 5.\frac{\varphi_1 + \varphi_2}{2}\right) \\
& + \cdots
\end{aligned}
$$

En relation avec la figure 6, e = L$_p$ modulo 2L$_p$, c'est-à-dire que les montages sont déphasés de 180° modulo 360°, cette différence s'écrit :

$$
\begin{aligned}
V_1(t) - V_2(t) = {} & 2.G.H_1 \cos\left(\omega t + \frac{\varphi_1 + \varphi_2}{2}\right) - 2.G.H_3.\cos\left(3\omega t + 3.\frac{\varphi_1 + \varphi_2}{2}\right) \\
& + 2.G.H_5.\cos\left(5\omega t + 5.\frac{\varphi_1 + \varphi_2}{2}\right) + \cdots
\end{aligned}
$$

On voit que les harmoniques 3 et 5 sont conservées et ont le même gain 2 que la fondamentale après l'opération de soustraction.

Pour obtenir une détermination précise du paramètre de rotation, on souhaite mesurer le signal filtré d'au moins l'harmonique de rang 3. Toutefois, toute compensation fixe de l'erreur apportée par les harmoniques est difficile à réaliser, notamment en ce qu'elle dépend des conditions de mesure (entrefer, position du capteur). Par ailleurs, une calibration est également difficilement envisageable pour une application en grand volume et bas coût.

La figure 8 illustre le filtrage de l'harmonique de rang 3 en fonction de la valeur du déphasage $\varphi_1$ - $\varphi_2$.

Lorsque la distance e est sensiblement égale à 2/3L$_p$ ou 4/3L$_p$ modulo 2L$_p$, la différence s'écrit :

$$
\begin{aligned}
V_1(t) - V_2(t) = {} & \sqrt{3}.G.H_1 \cos\left(\omega t + \frac{\varphi_1 + \varphi_2}{2}\right) + 0 \\
& - \sqrt{3}.G.H_5.\cos\left(5\omega t + 5.\frac{\varphi_1 + \varphi_2}{2}\right) + \cdots
\end{aligned}
$$

Dans ce cas, l'harmonique 3 est annulée, la fondamentale et l'harmonique 5 ont un gain de 1,73 après l'opération de soustraction. On a donc réalisé un filtre spatial de l'harmonique 3, tout en conservant 86,5% de la fondamentale.

De façon générale et en relation avec la figure 8, en considérant que le filtre de l'harmonique de rang 3 joue son rôle s'il enlève au moins 3 dB à sa valeur sans filtrage par rapport à l'amplitude de la fondamentale, il faut donc que :

$$\left| \frac{2.G.H_3.\sin\left(3\frac{\varphi_1 - \varphi_2}{2}\right)}{2.G.H_1.\sin\left(\frac{\varphi_1 - \varphi_2}{2}\right)} \right| \leq \frac{\sqrt{2}}{2}.\left|\frac{H_3}{H_1}\right|$$

$$\Leftrightarrow \left| \frac{\sin\left(3\frac{\varphi_1 - \varphi_2}{2}\right)}{\sin\left(\frac{\varphi_1 - \varphi_2}{2}\right)} \right| \leq \frac{\sqrt{2}}{2}$$

$\Leftrightarrow \varphi_1 - \varphi_2 \in [99° \; ; 148°]$ modulo 360°
ou $\varphi_1 - \varphi_2 \in [212° \; ; 261°]$ modulo 360°

Exprimé en distance, pour obtenir un filtrage de l'harmonique 3, il faut donc que les montages 4, 4' soient espacés d'une distance e mesurée le long de la normale N aux transitions 3 qui est telle que :

$$0{,}55L_p < e < 0{,}82L_p, \text{ modulo } 2L_p;$$

ou

$$1{,}18L_p < e < 1{,}45L_p, \text{ modulo } 2L_p.$$

En particulier, la distance e entre les montages 4, 4' peut varier dans les plages mentionnées ci-dessus pour optimiser le couple filtrage - gain. Par ailleurs, en fonction de l'encombrement disponible, les montages 4, 4' peuvent être alignés le long de la normale N aux transitions 3, le long de l'axe X ou décalés circonférentiellement (figure 6).

La suppression, ou au moins l'atténuation, de l'harmonique de rang 3 dans les signaux traités pour déterminer le paramètre de rotation est bénéfique relativement à la précision de ladite détermination, mais également pour les algorithmes de traitement du signal qui réalisent :

- la suppression de l'offset desdits signaux ;
- l'égalisation des amplitudes desdits signaux ;
- la correction de phase entre lesdits signaux.

**Revendications**

1. Système de détermination d'au moins un paramètre de rotation d'un organe tournant, ledit système comprenant :

    - un codeur (1) destiné à être associé en rotation à l'organe tournant de sorte à se déplacer conjointement avec lui, ledit codeur comprenant un corps présentant une périphérie cylindrique de rayon a autour d'un axe de révolution (X), ladite périphérie présentant une alternance de pôles magnétiques Nord (2n) et Sud (2s) de largeur l qui sont séparés par des transitions (3), chacune desdites transitions s'étendant suivant une hélice de pas p et d'angle $\alpha$ afin de former une piste magnétique (2) multipolaire qui est apte à émettre un champ magnétique périodique qui est tournant dans un plan perpendiculaire à ladite piste magnétique et auxdites transitions, ladite piste présentant $N_{pp}$ paires de pôles Nord (2n) et Sud (2s) et une largeur polaire $L_p$ mesurée le long d'une normale (N) aux transitions (3) qui sont tels que : $N_{pp} = \pi a/l$ et $L_p = p.\cos\alpha$ ;

    ledit système étant **caractérisé en ce qu'**il comprend deux capteurs aptes à détecter le champ magnétique tournant émis par ledit codeur au moyen, pour chaque capteur, d'un montage (4, 4') d'au moins deux éléments sensibles magnétiques (5), lesdits montages étant disposés à distance de lecture radiale de la piste magnétique (2) et chaque montage (4, 4') étant agencé pour délivrer des signaux ($V_{01}$, $V_{02}$; $V'_{01}$, $V'_{02}$) en quadrature, et **en ce que** les montages (4, 4') des deux capteurs sont espacés d'une distance e mesurée le long de la normale (N) aux transitions (3), et **en ce que** ledit système comprend en outre un dispositif de soustraction entre lesdits signaux des deux montages des deux dits capteurs pour former des signaux (SIN, COS) en quadrature.

**2.** Système de détermination selon la revendication 1, **caractérisé en ce que** le montage (4, 4') comprend deux circuits en pont de Wheatstone de quatre éléments sensibles (5), lesdits circuits étant disposés dans un plan perpendiculaire à la piste magnétique (2) de sorte à détecter le champ magnétique tournant dans ledit plan qui est émis par ladite piste.

**3.** Système de détermination selon l'une des revendications 1 ou 2, **caractérisé en ce que** chaque élément sensible (5) comprend au moins un motif à base d'un matériau magnétorésistif à effet tunnel dont la résistance varie en fonction du champ magnétique détecté.

**4.** Système de détermination selon l'une quelconque des revendications 1 à 3, **caractérisé en ce que** la distance e est telle que : $e = L_p$ modulo $2L_p$.

**5.** Système de détermination selon l'une quelconque des revendications 1 à 4, **caractérisé en ce que** la distance e est telle que :

$$0,55L_p < e < 0,82L_p, \text{ modulo } 2L_p;$$

ou

$$1,18L_p < e < 1,45L_p, \text{ modulo } 2L_p.$$

**6.** Système de détermination selon la revendication 5, **caractérisé en ce que** la distance e est sensiblement égale à $2/3L_p$ ou $4/3L_p$ modulo $2L_p$.


**Patentansprüche**

**1.** Bestimmungssystem für mindestens einen Rotationsparameter eines rotierenden Elements, wobei das System Folgendes umfasst:

- einen Codierer (1), der dazu bestimmt ist, drehbar mit dem rotierenden Element verbunden zu sein, so dass er sich gemeinsam mit ihm bewegt, wobei der Codierer einen Körper umfasst, der einen zylindrischen Umfang mit einem Radius um eine Drehachse (X) aufweist, wobei der Umfang einen Wechsel von magnetischen Nord- (2n) und Südpolen (2s) mit der Breite I aufweist, die durch Übergänge (3) voneinander getrennt sind, wobei sich jeder der Übergänge entlang einer Helix mit der Steigung p und dem Winkel $\alpha$ erstreckt, um eine multipolare Magnetspur (2) zu bilden, die ein periodisches Magnetfeld aussenden kann, das in einer Ebene senkrecht zur Magnetspur und zu den Übergängen rotiert, wobei die Spur $N_{pp}$ Paare von Nord- (2n) und Südpolen (2s) und eine Polarbreite $L_p$ aufweist, die entlang einer Normalen (N) zu den Übergängen (3) gemessen wird, welche wie folgt sind:

$$N_{pp} = \pi a/l \text{ und } L_p = p.\cos\alpha;$$

wobei das System **dadurch gekennzeichnet ist, dass** es zwei Sensoren umfasst, die dazu ausgelegt sind, das rotierende Magnetfeld, das vom Codierer mittels einer Anordnung (4, 4') von mindestens zwei empfindlichen magnetischen Elementen (5) für jeden Sensor zu erfassen, wobei die Anordnungen in einem radialen Leseabstand von der Magnetspur (2) angeordnet sind und jede Anordnung (4, 4') dazu angeordnet ist, Quadratursignale ($V_{01}$, $V_{02}$; $V'_{01}$, $V'_{02}$) zu liefern, und dadurch, dass die Anordnungen (4, 4') der beiden Sensoren um einen Abstand e, der entlang der Normalen (N) zu den Übergangen (3) gemessen wird, voneinander beabstandet sind, und dadurch, dass das System ferner eine Vorrichtung zur Subtraktion zwischen den Signalen der beiden Anordnungen der beiden Sensoren umfasst, um die Quadratursignale (SIN, COS) zu bilden.

**2.** Bestimmungssystem nach Anspruch 1, **dadurch gekennzeichnet, dass** die Anordnung (4, 4') zwei Wheatstone-Brückenschaltungen mit vier empfindlichen Elementen (5) umfasst, wobei die Schaltungen in einer Ebene senkrecht zur Magnetspur (2) angeordnet sind, um das in der Ebene rotierende Magnetfeld zu erfassen, das von der Spur ausgesendet wird.

**3.** Bestimmungssystem nach einem der Ansprüche 1 oder 2, **dadurch gekennzeichnet, dass** jedes empfindliche Element (5) mindestens ein Muster auf der Basis eines magnetoresistiven Tunnelmaterials umfasst, dessen Widerstand entsprechend dem erfassten Magnetfeld variiert.

**4.** Bestimmungssystem nach einem der Ansprüche 1 bis 3, **dadurch gekennzeichnet, dass** der Abstand e wie folgt ist:

$$e = L_p \ \text{Modulo} \ 2L_p.$$

**5.** Bestimmungssystem nach einem der Ansprüche 1 bis 4, **dadurch gekennzeichnet, dass** der Abstand e wie folgt ist:

$$0,55L_p < e < 0,82L_p, \ \text{Modulo} \ 2L_p;$$

oder

$$1,18L_p < e < 1,45L_p, \ \text{Modulo} \ 2L_p.$$

**6.** Bestimmungssystem nach Anspruch 5, **dadurch gekennzeichnet, dass** der Abstand e im Wesentlichen gleich $2/3L_p$ oder $4/3L_p$ Modulo $2L_p$ ist.

**Claims**

**1.** System for determining at least one rotation parameter of a rotating member, said system comprising:

- a coder (1) intended to be associated rotationally with the rotating member in such a way as to move jointly with it, said coder comprising a body having a cylindrical periphery with a radius a around an axis of revolution (X), said periphery having an alternation of North (2n) and South (2s) magnetic poles of width I which are separated by transitions (3), each one of said transitions extending along an helix of pitch p and of angle $\alpha$ so as to form a multipolar magnetic track (2) which is able to emit a periodic magnetic field which is rotating in a plane perpendicular to said magnetic track and to said transitions, said track having $N_{pp}$ pairs of North (2n) and South (2s) poles and a polar width $L_p$ measured along a normal (N) to the transitions (3) which are such that: $N_{pp} = \pi a/l$ and $L_p = p \cdot \cos\alpha$;

said system being **characterised in that** it comprises two sensors able to detect the rotating magnetic field emitted by said coder by means of, for each sensor, of a mounting (4, 4') of at least two sensitive magnetic elements (5), said mountings being disposed at a radial reading distance from the magnetic track (2) and each mounting (4, 4') being arranged to deliver signals ($V_{01}$, $V_{02}$; $V'_{01}$, $V'_{02}$) in quadrature, and **in that** mountings (4, 4') of the two sensors are spaced apart by a distance e measured along the normal (N) to the transitions (3), and **in that** said system further comprises a subtraction device between said signals from the two mountings of said two sensors to form signals (SIN, COS) in quadrature.

**2.** System for determining according to claim 1, **characterised in that** the mounting (4, 4') comprises two Wheatstone bridge circuits of four sensitive elements (5), said circuits being disposed in a plane perpendicular to the magnetic track (2) in such a way as to detect the magnetic field rotating in said plane which is emitted by said track.

**3.** System for determining according to one of claims 1 or 2, **characterised in that** each sensitive element (5) comprises at least one pattern with a tunnel magneto resistance material base of which the resistance varies according to the magnetic field detected.

**4.** System for determining according to one of claims 1 to 3, **characterised in that** the distance e is such that: $e = L_p$

modulo $2L_p$.

5. System for determining according one of claims 1 to 4, **characterised in that** the distance e is such that:

$$0.55L_p < e < 0.82L_p, \text{ modulo } 2L_p;$$

or

$$1.18L_p < e < 1.45L_p, \text{ modulo } 2L_p.$$

6. System for determining according to claim 5, **characterised in that** the distance e is substantially equal to $2/3L_p$ or $4/3L_p$ modulo $2L_p$.

Fig. 1a

Fig. 1b

Fig. 2

Fig. 3

Fig. 4

Fig. 5

Fig. 6

Fig. 7

Fig. 8

**EP 3 708 964 B1**

**RÉFÉRENCES CITÉES DANS LA DESCRIPTION**

**Documents brevets cités dans la description**

- WO 2006064169 A
- JP H02307011 B
- WO 2004083881 A
- WO 2018051011 A
- JP 2003097971 A